# EUROPEAN PATENT APPLICATION

(11) **EP 4 823 308 A1**
(43) Date of publication of application: **14.10.2026**
(21) Application number: 26164881.0
(22) Date of filing: 16.03.2026
(51) Int. Cl.: H10W 20/00, C23C 16/04, H10P 14/43, H10P 50/26

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 08.04.2025 JP 2025063799
(71) Applicant: Kokusai Electric Corporation, Tokyo 100-0004 (JP)
(72) Inventor: KAGA, Yukinao, Toyama-shi, Toyama, 939-2393 (JP)
(74) Representative: Bardehle Pagenberg Partnerschaft mbB Patentanwälte Rechtsanwälte

(57) **Abstract**

A technique includes (a) while supplying an adjustment gas into a first space (201) in which a substrate (200) including a recess formed on a surface of the substrate (200) is disposed, setting an internal pressure of the first space (201) to a first pressure; and (b) after (a), supplying an etching gas into the first space (201), wherein the internal pressure of the first space (201) is set to be lower than the first pressure during a low pressure period that is at least a partial period of (b).

## Description

### CROSS-REFERENCE TO RELATED APPLICATION

This application is based upon and claims the benefit of priority from Japanese Patent Application No. 2025-063799, filed on April 8, 2025, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device, a portion of a substance on a substrate may be etched.

### SUMMARY

Some embodiments of the present disclosure provide a technique capable of controlling a location that is easily etched and a location that is difficult to etch.

According to some embodiments of the present disclosure, there is provided a technique that includes (a) while supplying an adjustment gas into a first space in which a substrate including a recess formed on a surface of the substrate is disposed, setting an internal pressure of the first space to a first pressure; and (b) after (a), supplying an etching gas into the first space, wherein the internal pressure of the first space is set to be lower than the first pressure during a low pressure period that is at least a partial period of (b).

### BRIEF DESCRIPTION OF DRAWINGS

The accompanying drawings, which are incorporated in and constitute a part of the specification, illustrate embodiments of the present disclosure.
FIG. 1 is a schematic diagram illustrating a schematic configuration of a substrate processing apparatus according to a first embodiment.
FIG. 2 is a flowchart illustrating a substrate processing in the first embodiment.
FIG. 3 is a flowchart illustrating a film formation process in the first embodiment.
FIG. 4 is a flowchart illustrating an etching process in the first embodiment.
FIG. 5A is a schematic diagram illustrating a process in which a film for filling a recess is formed in a comparative example, and FIG. 5B is a schematic diagram illustrating a process in which a film for filling a recess is formed in the first embodiment.
FIG. 6 is a graph illustrating a variation in an internal pressure of a process chamber in the etching process of the first embodiment.
FIG. 7A is a graph illustrating another example of a variation in the internal pressure of the process chamber in the etching process of the first embodiment. FIG. 7B is a graph illustrating still another example of a variation in the internal pressure of the process chamber in the etching process of the first embodiment.
FIG. 8 is a flowchart illustrating an operation of a substrate processing apparatus according to a second embodiment.
FIG. 9 is a schematic diagram illustrating a substrate processing apparatus according to a third embodiment.
FIG. 10 is a schematic configuration diagram of a controller of the substrate processing apparatus according to the first embodiment, illustrating a control system of the controller in a block diagram.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

Hereinafter, one or a plurality of embodiments will be described with reference to the accompanying drawings. The accompanying drawings illustrate embodiments based on the principles of the present disclosure, but are provided for the understanding of the present disclosure and are not intended to be used to interpret the present disclosure in a limiting manner. The descriptions in the present disclosure are merely exemplary and do not limit the scope of the claims or applications of the present disclosure in any sense. The respective drawings are schematic, and dimensional relationships, proportions, and the like of respective elements illustrated in the drawings may not correspond to actual ones. Further, the dimensional relationships, proportions, and the like of respective elements may not be consistent among the multiple drawings.

It should be understood that the present embodiments are described in sufficient detail to enable those skilled in the art to implement the present disclosure, but other implementations and forms are also possible, and modifications in configuration and structure or substitutions of various elements may be made without departing from the scope and spirit of the technical idea of the present disclosure. Accordingly, the following description should not be interpreted in a restrictive manner.

The meanings of terms used in the present disclosure are described below.

In the present disclosure, the phrase "performing processing (also referred to as a process, a cycle, or a step, among others) a predetermined number of times" means performing the processing one time or multiple times. That is, it means performing the processing more than once. The number of times the processing is performed is appropriately selected according to filling characteristics and film thickness needed for a film to be finally formed.

The term "substrate" as used herein may refer to "a substrate itself," or may refer to "a stack (assembly) including a substrate and a predetermined layer, film, or the like formed on a surface of the substrate" (that is, a case where a substrate including a predetermined layer, film, or the like formed on a surface of the substrate is referred to as a wafer). Further, the term "surface of a substrate" as used herein may refer to "a surface (exposed surface) of a substrate itself," or may refer to "a surface of a predetermined layer, film, or the like formed on a substrate, that is, an outermost surface of a wafer as a stack."

Accordingly, when the phrase "supplying a predetermined gas to a substrate" is used herein, it may mean "supplying a predetermined gas directly to a surface (exposed surface) of a wafer itself," or may mean "supplying a predetermined gas to a layer, film, or the like formed on a substrate, that is, to an outermost surface of a wafer as a stack." Further, when the phrase "forming a predetermined layer (or film) on a substrate" is used herein, it may mean "forming a predetermined layer (or film) directly on a surface (exposed surface) of a substrate itself," or may mean "forming a predetermined layer (or film) on a layer, film, or the like formed on a substrate, i.e., on an outermost surface of the substrate as a stack."

In the present disclosure, the term "temperature" refers to a temperature of a substrate as a processing target, or an internal temperature of a process chamber into which the substrate is loaded, and the term "pressure" during processing refers to an internal pressure of the process chamber. Further, the term "processing time" refers to time during which that processing is continued. The notation of numerical ranges herein such as "1 to 2,000 Pa" means that the lower limit value and the upper limit value are included in that range. Accordingly, for example, "1 to 2,000 Pa" means "1 Pa or more and 2,000 Pa or less." The same applies to other numerical ranges, and this also applies throughout the following description.

### [First Embodiment]

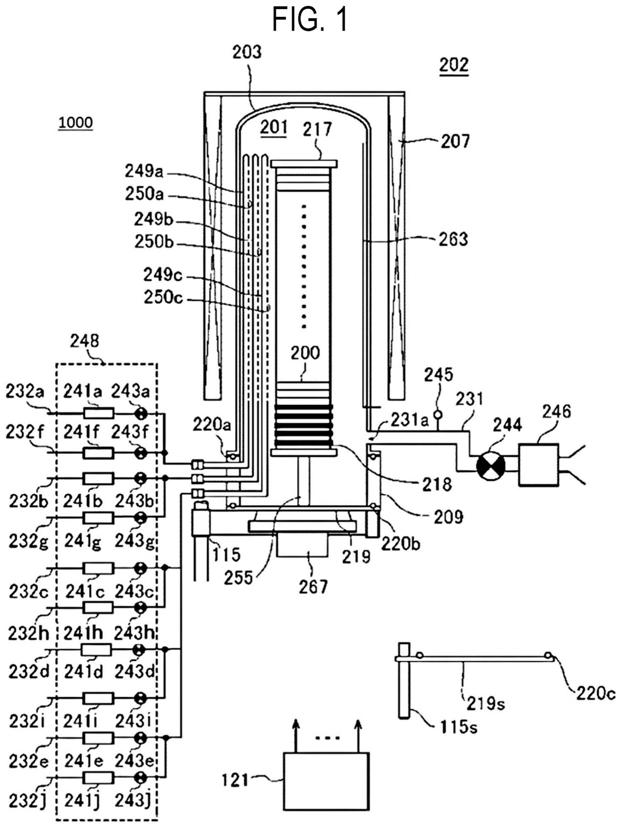

FIG. 1 is a schematic configuration diagram of a vertical process furnace of a substrate processing apparatus 1000 according to a first embodiment, and is a vertical cross-sectional view of a portion of the process furnace. As illustrated in FIG. 1, a process furnace 202 includes a heater 207 as a heating mechanism.

A reaction tube 203 is disposed inside the heater 207. The reaction tube 203 is formed in a cylindrical shape with a closed upper end and an open lower end. A manifold 209 is disposed below the reaction tube 203. The manifold 209 is formed in a cylindrical shape with its upper and lower ends both open. An O-ring 220a is installed as a seal between the manifold 209 and the reaction tube 203. A process container (reaction container) as a first process container mainly includes the reaction tube 203 and the manifold 209. A process chamber 201 is defined as a first space in a hollow cylindrical region of the process container. The process chamber 201 is configured to be capable of accommodating a wafer 200 serving as a substrate. Processing of the wafer 200 is performed inside the process chamber 201.

Nozzles 249a to 249c serving as first to third suppliers are installed respectively inside the process chamber 201 so as to penetrate a sidewall of the manifold 209. Gas supply pipes 232a to 232e are connected to the nozzles 249a to 249c.

The gas supply pipes 232a to 232e are installed, respectively, with mass flow controllers (MFCs) 241a to 241e, which serve as flow-rate controllers (flow-rate control parts), and valves 243a to 243e, which serve as opening/closing valves, in this order from an upstream side of a gas flow. Gas supply pipes 232f to 232j are connected, respectively, at a downstream side of the valves 243a to 243e of the gas supply pipes 232a to 232e. The gas supply pipes 232f to 232j are installed, respectively, with MFCs 241f to 241j and valves 243f to 243j in this order from an upstream side of a gas flow.

The nozzles 249a to 249c are each installed in a space between an inner wall of the reaction tube 203 and the wafer 200, from a lower portion to an upper portion of the inner wall of the reaction tube 203. Gas supply holes 250a to 250c for supplying gases are formed on side surfaces of the nozzles 249a to 249c, respectively. The gas supply holes 250a to 250c are each opened so as to oppose (face) an exhaust port 231a in a plane view, thereby enabling gases to be supplied toward the wafer 200. A plurality of gas supply holes 250a to 250c are provided from a lower portion to an upper portion of the reaction tube 203.

One end of the gas supply pipe 232a is connected to a supply source (not illustrated) of a precursor gas serving as one of the film formation gases. The precursor gas introduced from the precursor gas supply source into the gas supply pipe 232a is supplied into the process chamber 201 through the MFC 241a, the valve 243a, and the nozzle 249a.

One end of the gas supply pipe 232b is connected to a supply source (not illustrated) of a reaction gas serving as one of the film formation gases. The reaction gas introduced from the reaction gas supply source into the gas supply pipe 232b is supplied into the process chamber 201 through the MFC 241b, the valve 243b, and the nozzle 249b.

One end of the gas supply pipe 232c is connected to a supply source (not illustrated) of an etching gas. The etching gas introduced from the etching gas supply source into the gas supply pipe 232c is supplied into the process chamber 201 through the MFC 241c, the valve 243c, and the nozzle 249c.

One end of the gas supply pipe 232d is connected to a supply source (not illustrated) of an etching gas. A first etching gas introduced from the supply source of the first etching gas into the gas supply pipe 232d is supplied into the process chamber 201 through the MFC 241d, the valve 243d, and the nozzle 249c.

One end of the gas supply pipe 232e is connected to a supply source (not illustrated) of an etching gas. A second etching gas introduced from the supply source of the second etching gas into the gas supply pipe 232e is supplied into the process chamber 201 through the MFC 241e, the valve 243e, and the nozzle 249c.

One end of each of the gas supply pipes 232f to 232j is connected to a supply source (not illustrated) of an inert gas. The inert gas introduced from the inert gas supply source into the gas supply pipe 232f is supplied into the process chamber 201 through the MFC 241f, the valve 243f, and the nozzle 249a. The inert gas introduced from the inert gas supply source into the gas supply pipe 232g is supplied into the process chamber 201 through the MFC 241g, the valve 243g, and the nozzle 249b. The inert gas introduced from the inert gas supply source into the gas supply pipes 232h to 243j is supplied into the process chamber 201 through the MFCs 241h to 241j, the valves 243h to 243j, and the nozzle 249c. The inert gas functions, for example, as a purge gas, a carrier gas, a dilution gas, and an adjustment gas to be described later.

A precursor gas supply system mainly includes the gas supply pipe 232a, the MFC 241a, and the valve 243a. The nozzle 249a and the precursor gas supply source may also be included in the precursor gas supply system. A reaction gas supply system mainly includes the gas supply pipe 232b, the MFC 241b, and the valve 243b. The nozzle 249b and the reaction gas supply source may also be included in the reaction gas supply system. An etching gas supply system mainly includes the gas supply pipe 232c, the MFC 241c, and the valve 243c. The nozzle 249c and the etching gas supply source may also be included in the etching gas supply system. A first etching gas supply system mainly includes the gas supply pipe 232d, the MFC 241d, and the valve 243d. The nozzle 249c and the first etching gas supply source may also be included in the first etching gas supply system. A second etching gas supply system mainly includes the gas supply pipe 232e, the MFC 241e, and the valve 243e. The nozzle 249c and the second etching gas supply source may also be included in the second etching gas supply system. An inert gas supply system mainly includes the gas supply pipes 232f to 232j, the MFCs 241f to 241j, and the valves 243f to 243j.

When the inert gas is used as the adjustment gas to be described later, the inert gas supply system may be referred to as an adjustment gas supply system. When a film is formed on the wafer 200 by using the precursor gas and the reaction gas in a film formation process (step S31) to be described later, the precursor gas and the reaction gas may collectively be referred to as a film formation gas. In this case, the precursor gas supply system and the reaction gas supply system may collectively be referred to as a film formation gas supply system. Further, when a substance on the wafer 200 is etched using the first etching gas and the second etching gas as in a second embodiment to be described later, the first etching gas and the second etching gas may collectively be referred to as an etching gas. In this case, the first etching gas supply system and the second etching gas supply system may collectively be referred to as an etching gas supply system.

Among the various supply systems described above, any one or the entirety of supply systems may be configured as an integrated supply system 248 in which the valves 243a to 243j, the MFCs 241a to 241j, and others are integrated. The integrated supply system 248 is connected to each of the gas supply pipes 232a to 232j, and is configured such that supply operations of various gases into the gas supply pipes 232a to 232j, that is, opening/closing operations of the valves 243a to 243j and flow-rate regulation operations by the MFCs 241a to 241j are controlled by a controller 121 to be described later.

The exhaust port 231a is installed below a sidewall of the reaction tube 203 to exhaust an internal atmosphere of the process chamber 201. The exhaust port 231a is positioned to oppose (face) the nozzles 249a to 249c (gas supply holes 250a to 250c) with the wafer 200 interposed therebetween. The exhaust port 231a may be provided along the sidewall of the reaction tube 203 from a lower portion to an upper portion of the sidewall, that is, along a wafer arrangement region. An exhaust pipe 231 is connected to the exhaust port 231a. The exhaust pipe 231 is connected to a vacuum pump 246, which serves as a vacuum exhauster, through a pressure sensor 245, which serves as a pressure detector (pressure detection part) for detecting the internal pressure of the process chamber 201, and through an auto pressure controller (APC) valve 244, which serves as a pressure regulator (pressure regulation part). The APC valve 244 may perform or stop vacuum-exhaust inside the process chamber 201 by opening or closing the valve while the vacuum pump 246 is in operation. Further, the APC valve 244 is configured to be capable of regulating the internal pressure of the process chamber 201 by adjusting a valve opening degree based on pressure information detected by the pressure sensor 245 while the vacuum pump 246 is in operation. An exhaust system mainly includes the exhaust pipe 231, the APC valve 244, and the pressure sensor 245. The vacuum pump 246 may be regarded as being included in the exhaust system.

A seal cap 219 is installed below the manifold 209 and is capable of airtightly closing an opening at the lower end of the manifold 209. An O-ring 220b is installed on an upper surface of the seal cap 219 and serves as a seal that abuts against the lower end of the manifold 209. A rotator 267 is provided below the seal cap 219 via a rotation shaft 255 to rotate a boat 217 to be described later and the wafer 200 supported by the boat 217.

The seal cap 219 is raised or lowered vertically by a boat elevator 115 serving as a lift. The boat elevator 115 is configured as a transporter (transport mechanism) that loads and unloads (transports) the wafer 200 into and out of the process chamber 201 by raising or lowering the seal cap 219. A shutter 219s is installed below the manifold 209 and is capable of airtightly closing the opening at the lower end of the manifold 209 in a state where the seal cap 219 is lowered and the boat 217 is unloaded from the process chamber 201. An O-ring 220c is installed on an upper surface of the shutter 219s and serves as a seal that abuts against the lower end of the manifold 209. Opening/closing operations (such as an elevating operation or a rotational operation) of the shutter 219s are controlled by a shutter opening/closing mechanism 115s.

The boat 217, which serves as a substrate support, is configured to support a plurality of wafers 200, for example, 25 to 200 wafers, in such a state that the wafers 200 are arranged at intervals in a horizontal posture and in multiple stages along a vertical direction with centers of the wafers 200 aligned with one another. Heat insulation plates 218, which are made of a heat-resistant material such as quartz, SiC, or the like, are supported in multiple stages at a lower portion of the boat 217.

A temperature sensor 263 is installed as a temperature detector inside the reaction tube 203. The internal temperature of the process chamber 201 becomes a desired temperature distribution by regulating a state of supplying electric power to the heater 207 based on temperature information detected by the temperature sensor 263. The temperature sensor 263 is provided along the inner wall of the reaction tube 203.

As the precursor gas, a predetermined element-containing gas that contains a predetermined element, such as tungsten (W), titanium (Ti), molybdenum (Mo), tantalum (Ta), cobalt (Co), yttrium (Y), ruthenium (Ru), hafnium (Hf), zirconium (Zr), aluminum (Al), silicon (Si), or the like, may be used. One or more of these gases may be used as a precursor. A gas obtained by activating any of these gases using plasma may also be used as the precursor gas.

The predetermined element-containing gas may be, for example, a halogen-based predetermined element-containing gas that contains a predetermined element and a halogen element. Examples of the halogen-based predetermined element-containing gas may include hexachlorotungsten (WCl₆), hexafluorotungsten (WF₆), titanium tetrachloride (TiCl₄), titanium tetrafluoride (TiF₄), molybdenum pentachloride (MoCl₃), molybdenum pentafluoride (MoF₃), molybdenum dichloridedioxide (MoO₂Cl₂), molybdenum oxytetrachloride (MoOCl₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃Cl₃), pentachlorodisilane (Si₂HCl₅), hexachlorodisilane (Si₂Cl₆), and tetrafluorosilane (SiF₄), among others. Further, the predetermined element-containing gas may be a gas containing, for example, monosilane (SiH₄), disilane (Si₂H₆), trisilane (Si₃H₈), or tetrasilane (Si₄H₁₀). One or more of these gases may be used as the predetermined element-containing gas.

Further, the predetermined element-containing gas may be, for example, an organic-based predetermined element-containing gas containing a predetermined element and an organic ligand. Examples of the organic-based predetermined-element containing gas may include hexadimethylaminoditungsten (W₂[N(CH₃)₂]₆), bis(tert-butylimido)bis(dimethylamido)tungsten((t-C₄H₉NH)₂W=(N(CH₃)₂)₂), tetrakis(ethylmethylamino)titanium (Ti[N(C₂H₅)(CH₃)]₄), bis(ethylcyclopentadienyl)ruthenium (Ru(EtCp)₂), bis(cyclopentadienyl)ruthenium (Ru(Cp)₂), tetrakis(ethylmethylamino)hafnium (Hf[N(Me)Et]₄), tetrakis(diethylamino)hafnium (Hf[N(Et)₂]₄), tetrakis(dimethylamino)hafnium (Hf[N(Me)₂]₄), tris(dimethylamino)cyclopentadienylhafnium ((Cp)Hf[N(Me)₂]₃), tetrakis(ethylmethylamino)zirconium (Zr[N(Me)Et]₄), tetrakis(diethylamino)zirconium (Zr[N(Et)₂]₄), tetrakis(dimethylamino)zirconium (Zr[N(Me)₂]₄), tris(dimethylamino)cyclopentadienylzirconium ((Cp)Zr[N(Me)₂]₃), trimethylaluminum (Al(CH₃)₃), and tris(dimethylamino)silane (Si[N(CH₃)₂]₃H), among others. One or more of these gases may be used as the predetermined element-containing gas.

As the reaction gas, for example, gases including a reducing gas, an oxidizing gas, a nitriding gas, a sulfiding gas, a selenizing gas, and tellurizing gas may be used. One or more of these gases may be used as the reaction gas. A gas obtained by activating any of these gases using plasma may also be used as the reaction gas. For example, when the precursor gas is a predetermined element-containing gas and the reaction gas is a reducing gas, a film composed of a single predetermined element may be formed on the wafer 200. Further, for example, when the precursor gas is a predetermined element-containing gas and the reaction gas is any one of an oxidizing gas, a nitriding gas, a sulfiding gas, a selenizing gas, or a tellurizing gas, an oxide film of the predetermined element, a nitride film of the predetermined element, a sulfide film of the predetermined element, a selenide film of the predetermined element, or a telluride film of the predetermined element may be formed on the wafer 200.

Examples of the reducing gas may include a hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, monogermane (GeH₄) gas, digermane (Ge₂H₆) gas, and the like, and one or more of these gases may be used. Examples of the oxidizing gas may include oxygen (O₂), ozone (O₃), water vapor (H₂O), a mixed gas of H₂ and O₂, hydrogen peroxide (H₂O₂), nitrous oxide (N₂O), and the like, and one or more of these gases may be used. Examples of the nitriding gas may include nitrogen-hydride-based gases such as an ammonia (NH₃) gas, diazene (N₂H₂) gas, hydrazine (N₂H₄) gas, N₃H₈ gas, and the like, and one or more of these gases may be used. Examples of the sulfiding gas may include sulfane (H₂S), disulfane (H₂S₂), diammonium sulfide ((NH₄)₂S), dimethyl sulfide ((CH₃)₂S), and the like. One or more of these gases may be used as the sulfiding gas. Examples of the selenizing gas may include selane (H₂Se), diselane (H₂Se₂), dimethylselenium ((CH₃)₂Se), and the like. One or more of these gases may be used as the selenizing gas. Examples of the tellurizing gas may include tellane (H₂Te), ditellane (H₂Te₂), and dimethyl telluride ((CH₃)₂Te). One or more of these gases may be used as the tellurizing gas.

As the etching gas, for example, a gas containing a halogen element may be used. Examples of the gas containing a halogen element may include a WF₆ gas, chlorine (Cl₂) gas, fluorine (F₂) gas, NF₃ gas, HF gas, HCl gas, and the like.

As the inert gas, Gᵢₙ, for example, a nitrogen (N₂) gas or a noble gas such as an Ar gas, He gas, Ne gas, Xe gas, or the like may be used.

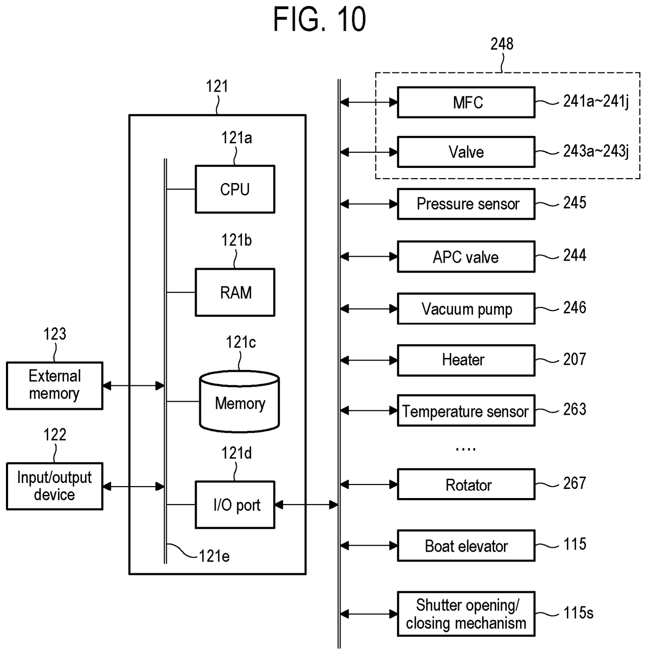

As illustrated in FIG. 10, the controller 121, which serves as a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. The controller 121 is connected to an input/output device 122, which is configured as, for example, a touch panel or the like.

The memory 121c is constituted by, for example, a flash memory, a hard disk drive (HDD), or the like. The memory 121c stores, in a readable manner, control programs for controlling operations of the substrate processing apparatus and process recipes in which procedures and conditions of substrate processing to be described later are stored. Each process recipe is a combination that causes, by the controller 121, execution of respective procedures in substrate processing to be described later so as to obtain predetermined results, and functions as a program (or program product). Hereinafter, the process recipes and the control programs are collectively referred to simply as programs (or program products). Further, the process recipes may also be referred to simply as recipes. The term "program" as used herein may refer to a case of solely including the recipe, a case of solely including the control program, or a case of including both. The RAM 121b is configured as a memory area (work area) in which programs, data, and others read by the CPU 121a are temporarily held.

The I/O port 121d is connected to the MFCs 241a to 241j, the valves 243a to 243j, the pressure sensor 245, the APC valve 244, the vacuum pump 246, the temperature sensor 263, the heater 207, the rotator 267, the boat elevator 115, the shutter opening/closing mechanism 115s, and others described above.

The CPU 121a is configured to be capable of reading and executing the control program from the memory 121c. The CPU 121a is also configured to be capable of reading the recipe from the memory 121c in response to an input such as an operation command from the input/output device 122. The CPU 121a is configured to be capable of, in accordance with contents of the read recipe, controlling flow-rate regulating operations of various gases by the MFCs 241a to 241j, opening/closing operations of the valves 243a to 243j, a pressure regulating operation by the APC valve 244 based on the pressure sensor 245 and an opening/closing operation of the APC valve 244, startup and shutdown operations of the vacuum pump 246, a temperature regulating operation of the heater 207 based on the temperature sensor 263, rotation and rotational-speed adjusting operations of the boat 217 by the rotator 267, a raising/lowering operation of the boat 217 by the boat elevator 115, an opening/closing operation of the shutter 219s by the shutter opening/closing mechanism 115s, and other operations.

The controller 121 may be configured by installing the aforementioned program stored in an external memory 123 into a computer. The external memory 123 includes, for example, a magnetic disk such as a HDD, an optical disk such as a CD, a semiconductor memory such as a USB memory, and the like. The memory 121c or the external memory 123 is configured as a computer-readable recording medium. Hereinafter, the memory 121c and the external memory 123 are collectively referred to simply as a recording medium. When the term "recording medium" is used herein, it may refer to a case of solely including the memory 121c, a case of solely including the external memory 123, or a case of including both. In addition, providing the program to the computer may be done using a communication means such as the Internet or a dedicated communication line without using the external memory 123.

As a process of manufacturing a semiconductor device, for example, a process of forming a film that fills an interior of a recess (for example, a pattern, a hole, or a trench) on a substrate (gap-fill) may be executed. In general, gases are more likely to reach an upper portion of the recess (a side closer to an opening) than a lower portion of the recess (a side closer to a bottom). Accordingly, when a thick film is formed on the upper portion before a film with a sufficient thickness is formed on the lower portion, voids and seams may be formed inside the film, which may degrade properties (for example, electrical conductivity) of the film.

In the present embodiment, in order to fill the recess on the substrate with high filling characteristics, a film formation process of forming a deposition film in the recess by supplying a film formation gas and an etching process of etching an upper portion of the deposition film by supplying an etching gas are alternately performed. Hereinafter, a method of forming a filling film according to this procedure may be referred to as an etching filling method or etching filling processing. By the etching filling processing, the deposition film may easily fill the recess with reduced voids and seams in the deposition film, that is, with high filling characteristics.

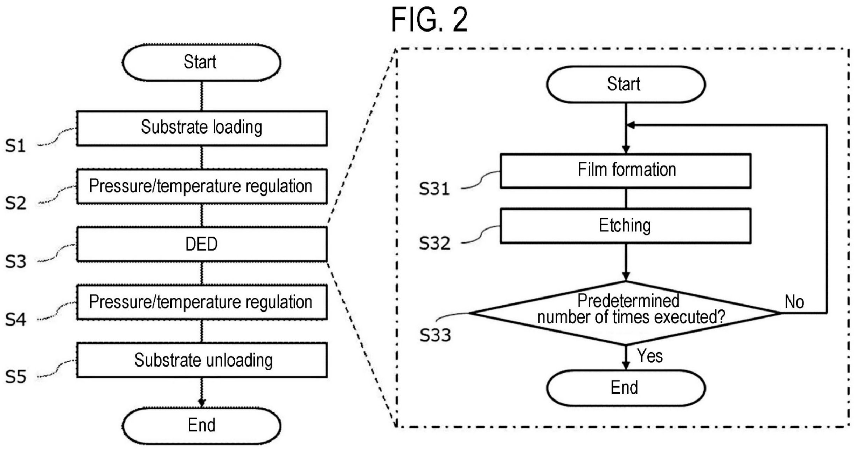

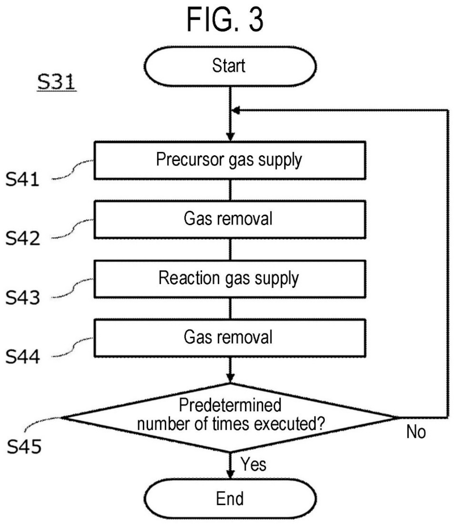

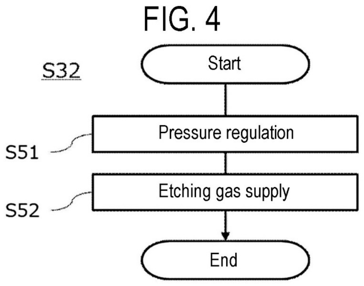

An etching filling processing (substrate processing) according to a first embodiment is described with reference to flowcharts of FIGS. 2 to 4. In the following description, operations of respective components constituting the substrate processing apparatus are controlled by the controller 121 illustrated in FIG. 10. FIG. 2 illustrates an overall flow of a film formation processing, FIG. 3 illustrates details of step S31 in FIG. 2, and FIG. 4 illustrates details of step S32 in FIG. 2.

In a processing for the wafer 200, first, the wafer 200 is charged into the boat 217 and loaded into the process chamber 201 (step S1). At this time, after the boat 217 is loaded into the process chamber 201, the temperature and pressure of the process chamber 201 are regulated by the heater 207 and the APC valve 244 (step S2), and an etching filling processing is executed (step S3). The etching filling processing is executed by repeating a film formation process (step S31) and an etching process (step S32) a predetermined number of times (step S33). In addition, a gas removal process of removing a gas inside the process chamber 201 may be performed between step S31 and step S32. This gas removal process is performed, for example, in the same manner as step S42 to be described later.

When step S3 is terminated, in step S4, the temperature and pressure of the process chamber 201 are regulated by the heater 207 and the APC valve 244 so as to return the process chamber 201 to normal pressure (atmospheric pressure). Specifically, for example, an inert gas such as a nitrogen (N₂) gas is supplied to the process chamber 201 and is then exhausted. Thus, the process chamber 201 is purged with the inert gas, and gases and others remaining in the process chamber 201 are removed from the process chamber 201 (inert gas purge). Thereafter, the atmosphere in the process chamber 201 is replaced with the inert gas (inert gas replacement), and the internal pressure of the process chamber 201 is returned to normal pressure (atmospheric pressure). Then, in step S5, the wafer 200 is unloaded from the process chamber 201. In this way, the film formation processing is terminated.

Details of operations of the film formation process (step S31) in the etching filling processing are described with reference to the flow chart of FIG. 3. In step S31, one or more kinds of film formation gases are supplied into the process chamber 201 to form a film on the wafer 200. Hereinafter, a case is described as an example in which step S31 includes a precursor gas supply process (step S41), a gas removal process (step S42), a reaction gas supply process (step S43), a gas removal process (step S44), and a process of performing steps S41 to S44 a predetermined number of times (step S45).

In the precursor gas supply process (step S41), a precursor gas as one of the film formation gases is supplied to the wafer 200. Step S41 is started by closing the valves 243b to 243e and opening the valve 243a. Further, the valves 243f to 243j may be opened to allow an inert gas to flow into the process chamber 201. Thereafter, step S41 is terminated by closing the valve 243a after a predetermined time is passed. By supplying the precursor gas to the wafer 200, a first layer containing a predetermined element is formed on the wafer 200.

In step S41, the APC valve 244 may be appropriately regulated so that the internal pressure of the process chamber 201 is set to, for example, 1 to 70,000 Pa. Further, a supply flow rate of the precursor gas controlled by the MFC 241a may be set to a sufficient amount to cover an entire surface of the wafer 200 (including an inner surface of a trench), for example, about 1 to 10,000 sccm. When an inert gas (such as a N₂ gas) is supplied, a supply flow rate of the inert gas may be set to, for example, 1 to 20,000 sccm. A temperature of the heater 207 may be set such that a temperature of the wafer 200 is, for example, 200 to 600 degrees C.

In the gas removal process (step S42), the process chamber 201 is vacuum-exhausted and/or purged to remove gases from the process chamber 201. Vacuum-exhaust of the process chamber 201 is performed, for example, by closing the valves 243a to 243j and exhausting the process chamber 201 using the vacuum pump 246. Purging of the process chamber 201 is performed, for example, by closing the valves 243a to 243e, opening the valves 243f to 243j, supplying an inert gas as a purge gas into the process chamber 201, and exhausting the process chamber 201 using the vacuum pump 246. Step S42 is terminated when a predetermined time is passed.

In step S43, a reaction gas as one of the film formation gases is supplied to the wafer 200. Step S43 is started by closing the valves 243a and 243c to 243e and opening the valve 243b. Further, the valves 243f to 243j may be opened to allow an inert gas to flow into the process chamber 201. Thereafter, step S43 is terminated by closing the valve 243b after a predetermined time is passed. By supplying the reaction gas to the wafer 200, the first layer is modified into a second layer (also referred to as forming a second layer on the wafer 200).

The supply of the reaction gas in step S43 may be performed by regulating the APC valve 244 such that the internal pressure of the process chamber 201 is set to, for example, about 0.01 to 13,300 Pa. Further, a supply flow rate of the reaction gas may be set to a sufficient amount to cover the entire surface of the wafer 200, for example, about 10 to 50,000 sccm. The temperature of the heater 207 may be the same as that in step S41.

In the gas removal process (step S44), the process chamber 201 is vacuum-exhausted and/or purged to remove gases from the process chamber 201. Step S44 is performed, for example, in the same manner as step S42.

The processing of steps S41 to S44 constitutes one cycle, and this processing is executed a predetermined number of times (n times, where n is an integer of 1 or more). As a result, a deposition film D is formed on a surface of the wafer 200, including within a trench T, with a predetermined thickness (for example, 0.1 to 10 nm). It is desirable to repeat the above-described cycle multiple times.

Next, details of operations of the etching process (step S32) in the etching filling processing are described with reference to the flow chart of FIG. 4. In step S32, at least a portion of the deposition film D is etched by supplying one or more kinds of etching gases into the process chamber 201. Hereinafter, a case is described as an example in which step S32 includes a pressure regulation step (step S51) and an etching gas supply step (step S52). The pressure regulation step (step S51) is a step of setting the internal pressure of the process chamber 201 to a first pressure while supplying an inert gas as an adjustment gas into the process chamber 201. Step S52 is a step of supplying an etching gas into the process chamber 201. In addition, in step S32, a cycle of steps S51 and S52 may be performed multiple times.

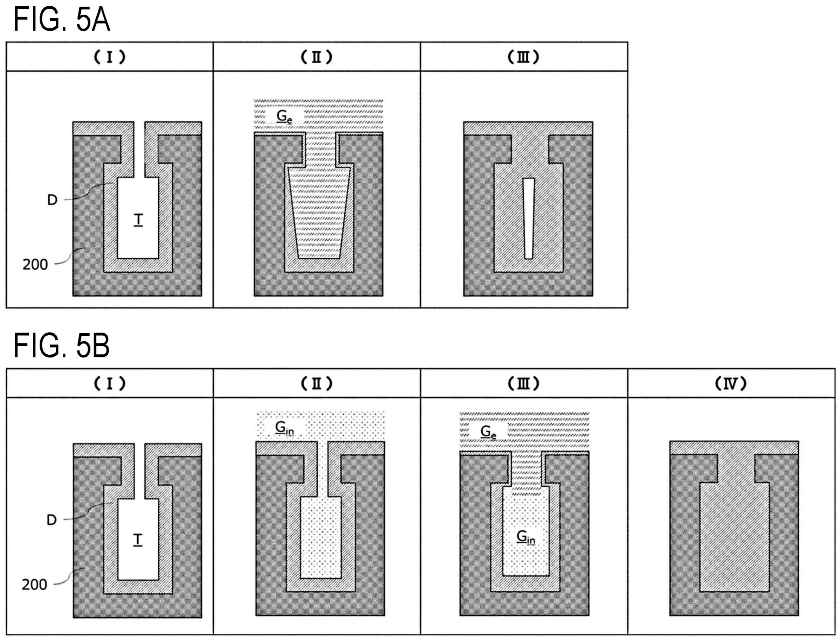

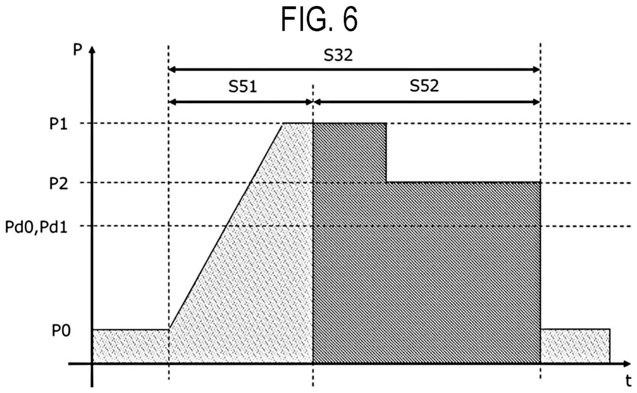

Herein, the etching filling processing (step S3) for the trench T formed as a recess on the wafer 200 is described with reference to FIGS. 5A and 5B and FIG. 6. FIG. 5A schematically illustrates a process in which a film for filling a recess is formed when the pressure regulation step (step S51) is omitted from step S32 of the present embodiment (hereinafter referred to as a comparative example). Further, FIG. 5B schematically illustrates a process in which a film for filling the recess is formed in step S32 including steps S51 and S52. The comparative example is performed in the same manner as the processing in the present embodiment, except for the presence or absence of step S51. In addition, in FIGS. 5A and 5B, the trench T in which an upper portion is narrower than middle and lower portions is illustrated as an example of the recess, but the present disclosure is not limited to such a trench with a narrow upper portion and is also applicable to a trench in which an upper portion is wider than middle and lower portions (for example, a tapered trench), or a trench with a substantially uniform width as a whole (for example, a rectangular trench). Further, depth and aspect ratio of the trench are not limited. FIG. 6 is a diagram schematically illustrating a variation in the internal pressure of the process chamber 201 in step S32 (and before and after step S32) of the present embodiment.

In FIG. 5A, (I) illustrates a state where, by step S31 of the comparative example, the deposition film D is deposited in the trench T to a thickness that does not cause an upper portion of the trench T to be blocked. Thereafter, in step S32 of the comparative example, the etching gas supply step (step S52) is performed without performing the pressure regulation step (step S51). In step S52, an etching gas Gₑ is supplied into the process chamber 201. Specifically, step S52 is started by closing the valves 243a, 243b, 243d, and 243e and opening the valve 243c. Further, the valves 243f to 243j may be opened to allow an inert gas to flow into the process chamber 201. Thereafter, step S52 is terminated by closing the valve 243c after a predetermined time is passed. By supplying the etching gas Gₑ to the wafer 200, at least a portion of the deposition film D is etched (also referred to as being removed from the wafer 200).

As illustrated in (II) of FIG. 5A, in step S52 of the comparative example, during etching of the deposition film, the etching gas Gₑ may penetrate into middle and lower portions of the trench T, thereby also etching the deposition film on the middle and lower portions of the trench T. In this case, it becomes difficult for the thickness of the deposition film on the middle and lower portions of the trench T to increase even when film formation and etching are combined. Therefore, seams or voids may remain in the deposition film D, as illustrated in (III) of FIG. 5A. Such a phenomenon tends to occur more easily as an aspect ratio of the recess (a ratio of a depth of the recess to a width or area of an opening of the recess) increases.

In the present embodiment, after the deposition film D is deposited in the trench T by the film formation process (step S31) as illustrated in (I) of FIG. 5B, the pressure regulation step (step S51) and the etching gas supply step (step S52) are performed as step S32. Hereinafter, a case is described as an example in which the internal pressure P0 of the process chamber 201 after step S31 is reduced to, for example, about 20 Pa or less by vacuum-exhaust, as illustrated in FIG. 6.

In step S51, while supplying an adjustment gas into the process chamber 201, the internal pressure of the process chamber 201 is set to a first pressure (hereinafter referred to as a pressure P1). Specifically, while the valves 243f to 243j are opened to supply an inert gas Gᵢₙ (for example, a nitrogen (N₂) gas) as the adjustment gas into the process chamber 201, an opening degree of the APC valve 244 is controlled, thereby gradually increasing the internal pressure of the process chamber 201 to the pressure P1 higher than a pressure Pd, as illustrated in FIG. 6. Thereafter, as illustrated in FIG. 6, after the internal pressure of the process chamber 201 reaches the pressure P1, the internal pressure of the process chamber 201 may be maintained at the pressure P1. This may reduce a variation in pressure at a start of step S52 for each cycle. By step S51, an interior of the trench T may be filled with an atmosphere of the inert gas Gᵢₙ at a relatively high pressure, as illustrated in (II) of FIG. 5B. In addition to the nitrogen (N₂) gas, a noble gas such as an Ar gas, He gas, Ne gas, or Xe gas may be used as the inert gas Gᵢₙ.

After step S51, the etching gas supply step (step S52) of supplying an etching gas into the process chamber 201 is performed. Step S52 in the present embodiment is started and terminated in the same procedure as in the comparative example. As a result, the internal pressure of the process chamber 201 varies, for example, as illustrated in FIG. 6. Herein, it is desirable that the internal pressure of the process chamber 201 be set to be lower than the pressure P1 during at least a partial period of step S52. Hereinafter, a case is described as an example in which the internal pressure of the process chamber 201 is maintained at the pressure P1 for a while from a start time of step S52, and thereafter is reduced to a pressure P2 lower than the pressure P1 during a subsequent period, as illustrated in FIG. 6. Further, in step S52, a period in which the internal pressure of the process chamber 201 is lower than the pressure P1 is referred to as a low pressure period, and a period in which the internal pressure of the process chamber 201 is equal to or higher than the pressure P1 is referred to as a high pressure period.

According to the present embodiment, one or more of the following effects are obtained, in addition to the above-described effects.

It is desirable that step S52 be performed after step S51. Movement of molecules of the etching gas Gₑ toward the middle and lower portions of the trench T is hindered by molecules of the inert gas Gᵢₙ in the trench T. Also, by performing step S52 after step S51, a difference between the internal pressure of the process chamber 201 at the start time of step S52 and the internal pressure of the process chamber 201 during the low pressure period may be increased. This further hinders the movement of molecules of the etching gas Gₑ toward the middle and lower portions of the trench T. In this regard, etching on the middle and lower portions of the trench T may be prevented.

It is desirable that step S52 be performed so as to include the low pressure period. In other words, it is desirable that the internal pressure of the process chamber 201 be reduced from the pressure P1 to a lower pressure during at least a part of step S52. This is explained below.

A case is considered in which the internal pressure of the process chamber 201 is maintained at the pressure P1, so that gas movement between an inside and an outside of the trench T due to a pressure difference between the inside and the outside of the trench T is prevented. Even in such a case, etching on the middle and lower portions of the trench T tends to progress since a concentration difference of the etching gas Gₑ between the inside and the outside of the trench T decreases due to diffusion of the etching gas as time passes from the start of step S52. By performing step S52 so as to include the low pressure period, a gas flow from the inside of the trench T toward the outside of the trench T by a pressure difference between the inside and the outside of the trench T may be formed from the start to an end of step S52. As a result, the movement of molecules of the etching gas Gₑ toward the middle and lower portions of the trench T may be further hindered.

In this way, in step S32, as illustrated in (III) of FIG. 5B, etching is prevented on the lower portion of the trench T, while etching progresses more easily on the upper portion of the trench T than on the lower portion. Thereafter, in step S33, steps S31 and S32 are performed a predetermined number of times. As a result, filling of the trench T on the middle and lower portions may be completed more easily before the upper portion is blocked, thereby facilitating formation of the deposition film D without seams or voids in the trench T, as illustrated in (IV) of FIG. 5B.

Further, if the high pressure period is maintained for a long time, movement of the etching gas Gₑ toward the lower portion of the trench T may occur due to a concentration difference of the etching gas between the outside of the trench T and the lower portion of the trench T. By providing the low pressure period after the high pressure period, gas movement from the lower portion of trench T toward the outside of the trench T occurs due to a pressure difference between the outside and the lower portion of trench T during at least a part of the low pressure period. As a result, the etching gas becomes less likely to reach the lower portion of the trench T. In this way, etching on a deep side may be further prevented.

In step S52, it is desirable that the internal pressure of the process chamber 201 be set to be equal to or lower than the pressure P1. In other words, in step S52, it is desirable that the internal pressure of the process chamber 201 not be set to be higher than the pressure P1. By this, movement of molecules of the etching gas Gₑ from the outside of the trench T toward the inside of the trench T by a pressure difference between the outside and the inside of the trench T may be more easily prevented. Accordingly, etching on the middle and lower portions of the trench T may be further prevented. In addition, the internal pressure of the process chamber 201 may be set to be equal to or higher than the pressure P1 during the high pressure period. Even in this case, at least some of the above-described effects may be obtained.

It is desirable that the low pressure period includes an end time of step S52. In other words, it is desirable that the internal pressure of the process chamber 201 be set to be lower than the pressure P1 at the end time of step S52. By this, at the end time of step S52, where a concentration of the etching gas Gₑ in the trench T is likely to increase due to the progress of diffusion of the etching gas Gₑ, a partial pressure of the etching gas Gₑ in the trench T may be reduced. Accordingly, etching on the middle and lower portions of the trench T may be further prevented.

It is desirable that the internal pressure of the process chamber 201 at the start time of step S52 be set to be equal to or lower than the pressure P1. By this, movement of molecules of the etching gas Gₑ from the outside of the trench T toward the inside of the trench T by a pressure difference between the outside and the inside of the trench T may be more easily prevented at the start time of step S52. Accordingly, etching on the middle and lower portions of the trench T may be prevented.

It is desirable that the internal pressure of the process chamber 201 at the start time of step S52 be set to the pressure P1. By this, movement of molecules of the inert gas Gᵢₙ from the inside of the trench T toward the outside of the trench T due to a pressure difference between the outside and the inside of the trench T may be more easily prevented at the start time of step S52. Further, since it becomes easier to increase a difference between the internal pressure of the process chamber 201 during the high pressure period and the internal pressure of the process chamber 201 during the low pressure period, movement of molecules of the etching gas Gₑ from the outside to the inside of the trench T may be more easily prevented. Accordingly, etching on the middle and lower portions of the trench T may be prevented since a partial pressure of the etching gas Gₑ in the lower portion of the trench T may be more easily reduced.

As illustrated in FIG. 6, it is desirable that the internal pressure of the process chamber 201 at the time when the supply of the film formation gas into the process chamber 201 is started in step S31 (hereinafter referred to as a pressure Pd0) be set to be lower than the pressure P1. As a result, in step S31, collisions between molecules of the film formation gas and molecules of the gas in the trench T are less likely to occur, so that the film formation gas may more easily reach the lower portion of the trench T. Accordingly, a difference in ease of progress of film formation between the upper portion and the lower portion of the trench T may be reduced. In addition, in the present embodiment, in steps S41 and S43, one of the internal pressures (referred to as Pd01 and Pd02, respectively) of the process chamber 201 at the times when the supply of the precursor gas and the supply of the reaction gas into the process chamber 201 are started may be used as the pressure Pd0. In either case, the above-described effects may be obtained. Herein, the precursor gas tends to exhibit a large difference between an amount of reaching the upper portion and an amount of reaching the lower portion of the trench T. Therefore, it is particularly desirable that Pd01 be set to be lower than the pressure P1. Further, it is more desirable to set both Pd01 and Pd02 to be lower than the pressure P1. In this case, the above-described effects may be obtained more easily.

As illustrated in FIG. 6, it is desirable that the pressure P1 be higher than a film formation pressure Pd1, which is the internal pressure of the process chamber 201 in step S31. By this, etching on the middle and lower portions of the trench T may be prevented since a sufficient amount of inert gas may be easily filled into the recess in step S51. In addition, in the present embodiment, in steps S41 and S43, one of the internal pressures of the process chamber 201 during the supply of the precursor gas and the supply of the reaction gas into the process chamber 201 (referred to as Pd11 and Pd12, respectively) may be used as the pressure Pd1. In either case, the above-described effects may be obtained.

As illustrated in FIG. 6, it is desirable that the internal pressure of the process chamber 201 during the low pressure period be higher than the film formation pressure Pd1. In other words, it is desirable that the internal pressure of the process chamber 201 not be set to be equal to or lower than the pressure Pd1 during the low pressure period. By this, a pressure difference between the outside and the inside of trench T may be easily kept small, so that the inert gas filled into the trench T in step S51 may be made less likely to move to the outside of the trench T. Accordingly, the above-described effects may be more easily obtained.

In step S52, it is desirable that the internal pressure of the process chamber 201 be set to be lower than the pressure P1 from a start of the low pressure period until the end of step S52. As a result, the pressure outside the trench T is less likely to be higher than the pressure inside the trench T due to a pressure difference, preventing movement of the etching gas into the trench T. Accordingly, the above-described effects may be more easily obtained. Further, in step S52, it is desirable not to increase the internal pressure of the process chamber 201 after the low pressure period is started. As a result, the above-described effects may be more easily obtained since movement of the etching gas from the outside to the inside of the trend T by a pressure difference may be further prevented.

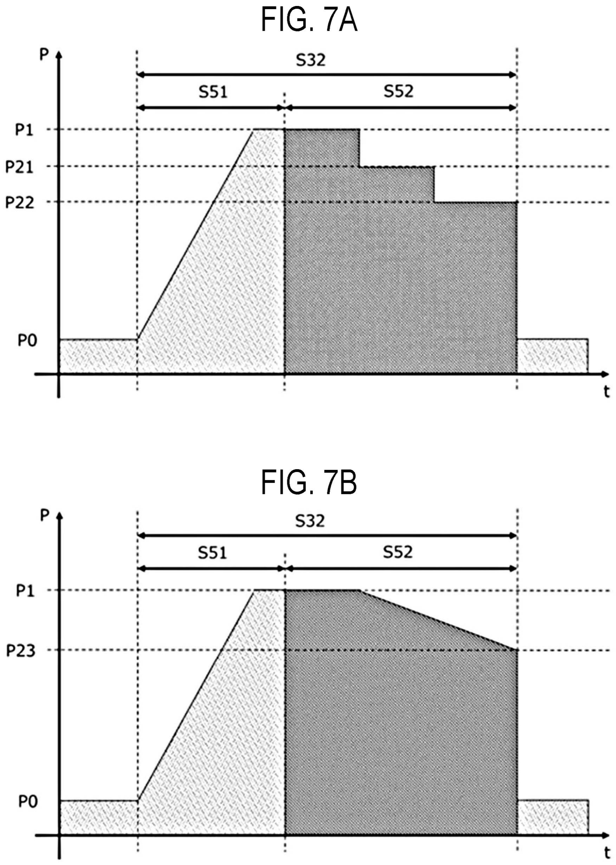

FIG. 7A illustrates another example of a variation in the internal pressure of the process chamber 201 in step S52. In the example of FIG. 7A, in step S52, a period in which the internal pressure of the process chamber 201 is the pressure P1 (referred to as the high pressure period as in FIG. 6), a period in which the internal pressure of the process chamber 201 is a pressure (hereinafter referred to as P21) that is lower than the pressure P1 and is equal to or higher than a second pressure (a first low pressure period), and a period in which the internal pressure of the process chamber 201 is a pressure (hereinafter referred to as P22) that is lower than the pressure P21 and lower than the pressure P1 (a second low pressure period) are provided in this order. That is, in the example of FIG. 7A, the low pressure period includes the first low pressure period and the second low pressure period. When switching from the high pressure period to the first low pressure period, and when switching from the first low pressure period to the second low pressure period, a pressure outside the trench T becomes lower than a pressure on the lower portion of the trench T, and thus a gas present on the lower portion of wrench T moves to the outside of the trench T. As a result, the etching gas becomes less likely to reach the lower portion of the trench T.

Further, during the first low pressure period, movement of the etching gas from the outside toward the lower portion of the trench T occurs as time passes due to a pressure difference and a difference in concentration of the etching gas between the outside and the lower portion of the trench T. By providing the second low pressure period after the first low pressure period, gas movement from the lower portion toward the outside of the trench T occurs due to a pressure difference between the outside and the lower portion of trench T during at least a part of the second low pressure period. As a result, the etching gas becomes less likely to reach the lower portion of the trench T. In this way, the progress of etching on the lower portion of the trench T may be further prevented.

FIG. 7B illustrates still another example of a variation in the internal pressure of the process chamber 201 in step S52. In the example illustrated in FIG. 7B, the internal pressure of the process chamber 201 continuously varies (decreases) during the low pressure period. For example, in the example of FIG. 7B, the internal pressure continuously varies from the pressure P1 to P23 during the low pressure period. A method of varying the internal pressure is not limited thereto, and at the start of the low pressure period, the internal pressure of the process chamber 201 may be set to a value lower than the pressure P1. Further, a gradient of the pressure variation may vary midway. By continuously varying the internal pressure of the process chamber 201 during at least a part of the low pressure period in this manner, gas movement from the inside to the outside of the trench T may be continuously generated. Accordingly, the progress of etching on the middle and lower portions of the trench T may be prevented.

### [Second Embodiment]

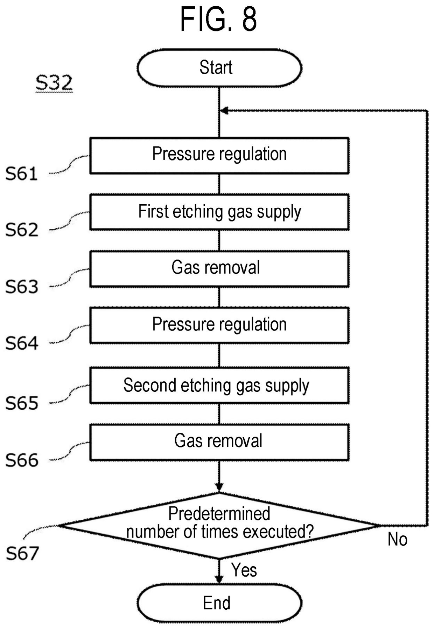

Next, a substrate processing apparatus 1000 and a method of processing a substrate according to a second embodiment are described with reference to FIG. 8. An apparatus configuration of the substrate processing apparatus 1000 of the second embodiment may be the same as that of the first embodiment (FIG. 1).

In the second embodiment, the etching process (step S32) differs from that of the first embodiment. The other processes may be performed in the same manner as in the first embodiment. Specifically, the etching process (S32) in the second embodiment includes a first etching process using a first etching gas and a second etching process using a second etching gas. Then, a low pressure period similar to that of the embodiment described above is provided in both of these two processes. This difference is described below with reference to a flowchart of FIG. 8.

First, a pressure regulation process (step S61) is performed in the same procedure as step S51 to regulate the internal pressure of the process chamber 201. Thereafter, a first etching gas is supplied to the wafer 200 to execute a first etching processing (step S62). Specifically, step S62 is started by closing the valves 243a to 243c and 243e and opening the valve 243d. Further, the valves 243f to 243j may be opened to allow an inert gas to flow into the process chamber 201. Thereafter, step S62 is terminated by closing the valve 243d after a predetermined time is passed. As a result, a thin modified layer is formed on a surface of the wafer 200. Thereafter, a gas removal process (step S63) in which the process chamber 201 is vacuum-exhausted and/or purged in the same procedure as step S42 is performed to remove gases from the process chamber 201. Thereafter, a pressure regulation process (step S64) is performed in the same procedure as step S51 to regulate the internal pressure of the process chamber 201. Thereafter, a second etching gas is supplied to the wafer 200 to perform a second etching processing (step S65). Specifically, step S65 is started by closing the valves 243a to 243d and opening the valve 243e. Further, the valves 243f to 243j may be opened to allow an inert gas to flow into the process chamber 201. Thereafter, step S65 is terminated by closing the valve 243e after a predetermined time is passed. Thereafter, a gas removal process (step S66) in which the process chamber 201 is vacuum-exhausted and/or purged in the same procedure as step S42 is performed to remove gases from the process chamber 201. The above steps S61 to 66 are performed a predetermined number of times (once or multiple times).

The first etching gas and the second etching gas may be appropriately set according to a film as an etching target. For example, the first etching gas and the second etching gas may be appropriately selected from among a fluorine (F)-containing gas, a chlorine (Cl)-containing gas, an oxidizing gas, a Group 13 element-containing gas, and a Group 15 element-containing gas.

In the second embodiment, movement of molecules of the first etching gas and the second etching gas toward the middle and lower portions of the trench T may be hindered as in the first embodiment. Accordingly, etching in the middle and lower portions of the trench T may be prevented as in the first embodiment. In addition, either step S62 or step S65 may not include a low pressure period. Further, at least one of step S61 and step S64 may be omitted. In such a case, at least some of the effects of the first embodiment may be obtained.

### [Third Embodiment]

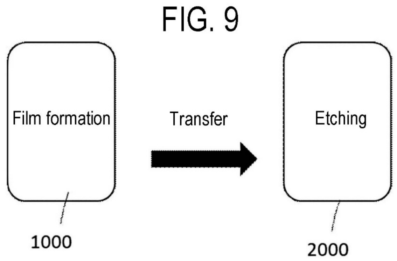

Next, a substrate processing apparatus and a substrate processing method according to a third embodiment are described with reference to FIG. 9. In the third embodiment, a first substrate processing apparatus 1000 including a first process container in which a first space (or the process chamber 201) is formed, and a second substrate processing apparatus 2000 including a second process container in which a second space is formed are used. In the third embodiment, after performing the film forming process (step S31) in the first process chamber of the first substrate processing apparatus 1000, the wafer 200 as a processing target is transferred from the first process chamber of the first substrate processing apparatus 1000 to the second process chamber of the second substrate processing apparatus 2000, and the etching process (step S32) is performed in the second process chamber. In this case as well, at least some of the effects of the first embodiment may be obtained.

### (Other Embodiments)

Although the embodiments of the present disclosure are specifically described above, the present disclosure may not be limited to the above-described embodiments, and various modifications may be made without departing from the gist of the present disclosure. For example, in the above-described embodiments, an example is described in which a deposition film fills a recess such as the trench T by a DED(Deposition Etch Deposition) method, but the present disclosure is not limited thereto, and the technique of the present disclosure may be widely applied to etching a film that does not fill a recess such as a trench. Further, the technique of the present disclosure may be applied to an etching process that is not preceded or followed by a film formation process. In this case as well, at least some of the above-described effects may be obtained. The above-described effects may be obtained even when a location near the opening of the recess is replaced with a location of the substrate surface that is easily etched, and a location near the deep side of the recess is replaced with a location of the substrate surface that is difficult to be etched. Accordingly, it may be said that a location that is easily etched and a location that is difficult to etch may be controlled according to the technique of the present disclosure.

In the above-described embodiments, an example is described in which a substrate is processed using a batch-type substrate processing apparatus that processes a plurality of substrates at a time. The present disclosure is not limited to the above-described embodiments, and may be suitably applied, for example, to a case in which a film is formed using a single-wafer-type substrate processing apparatus that processes one or several substrates at a time. Further, in the above-described embodiments, an example is described in which a substrate is processed using a substrate processing apparatus with a hot wall type process furnace. The present disclosure is not limited to the above-described embodiments, and may be suitably applied to a case in which a film is formed using a substrate processing apparatus with a cold wall type process furnace. Even when these substrate processing apparatuses are used, each processing may be performed using processing procedures and processing conditions similar to those of the above-described embodiments and modifications, and effects similar to those of the above-described embodiments and modifications may be obtained.

In the above-described embodiments, the example is described in which the inert gas is used as the adjustment gas. The present disclosure is not limited to the above-described embodiments, and for example, a reactive gas that exhibits chemical reactivity with respect to the substrate may be used as the adjustment gas. However, in order to effectively prevent etching in the middle and lower portions of the recess, it is desirable to use, as the adjustment gas, a gas with lower etching properties than an etching gas. Further, it is more desirable to use a gas that does not etch a film as the adjustment gas. In this case as well, the effects similar to those of the above-described embodiments and modifications may be obtained.

Further, the present disclosure is not limited to semiconductor manufacturing processes. For example, the present disclosure may also be applied to substrate processing such as manufacturing processes of liquid crystal devices, manufacturing processes of solar cells, manufacturing processes of light-emitting device, processing processes of glass substrate, processing processes of ceramic substrates, processing processes of conductive substrates, and the like.

Further, it is possible to replace a part of a configuration of one embodiment with a configuration of another embodiment, and it is also possible to add a configuration of one embodiment to a configuration of another embodiment. Further, it is also possible to add, delete, or replace a part of a configuration of each embodiment with another configuration.

According to the present disclosure, it is possible to control a location that is easily etched and a location that is difficult to etch.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
(a) while supplying an adjustment gas into a first space (201) in which the substrate (200) including a recess formed on a surface of the substrate (200) is disposed, setting an internal pressure of the first space (201) to a first pressure; and
(b) after (a), supplying an etching gas into the first space (201),
wherein the internal pressure of the first space (201) is set to be lower than the first pressure during a low pressure period that is at least a partial period of (b).

2. The method of Claim 1, wherein the low pressure period includes an end time of (b).

3. The method of Claim 1 or 2, wherein the internal pressure of the first space (201) at a start time of (b) is set to be equal to or lower than the first pressure.

4. The method of any one of Claims 1 to 3, wherein the internal pressure of the first space (201) is set to be equal to or higher than the first pressure during a high pressure period including a start time of (b), and
wherein the low pressure period is set after the high pressure period.

5. The method of any one of Claims 1 to 4, wherein (c) supplying a film formation gas into a second space in which the substrate (200) is present to form a film on the substrate (200) and a combination of (a) and (b)
are each performed a predetermined number of times.

6. The method of Claim 5, wherein an internal pressure of the second space at a time when supply of the film formation gas is started in (c) is set to be lower than the first pressure.

7. The method of Claim 5 or 6, wherein the first pressure is set to be higher than an internal pressure of the second space in (c).

8. The method of any one of Claims 5 to 7, wherein the internal pressure of the first space (201) in the low pressure period is set to be higher than an internal pressure of the second space in (c).

9. The method of any one of Claims 5 to 8, wherein the film is formed so as to fill the recess.

10. The method of any one of Claims 5 to 9, wherein the second space is the same as the first space (201).

11. The method of any one of Claims 5 to 10, wherein the second space is different from the first space (201).

12. The method of any one of Claims 1 to 11, wherein the etching gas includes a first etching gas and a second etching gas,
wherein (b) includes:
(b1) supplying the first etching gas into the first space (201) to form a modified layer on the substrate (200); and
(b2) supplying the second etching gas into the first space (201) to remove the modified layer from the substrate (200), and
wherein the low pressure period is provided in at least one selected from the group of (b1) and (b2).

13. A method of manufacturing a semiconductor device, comprising the method of Claim 1.

14. A program that causes, by a computer, a substrate processing apparatus (1000) to perform:
(a) while supplying an adjustment gas into a first space (201) in which a substrate (200) including a recess formed on a surface of the substrate (200) is disposed, setting an internal pressure of the first space (201) to a first pressure; and
(b) after (a), supplying an etching gas into the first space (201),
wherein the internal pressure of the first space (201) is set to be lower than the first pressure during a low pressure period that is at least a partial period of (b).

15. A substrate processing apparatus (1000) comprising:
a first process container in which a first space (201) is formed;
an adjustment gas supply system configured to supply an adjustment gas into the first space (201);
an etching gas supply system configured to supply an etching gas into the first space (201);
an exhaust system configured to control an internal pressure of the first space (201); and
a controller (121) configured to be capable of controlling the adjustment gas supply system, the etching gas supply system, and the exhaust system so as to perform:
(a) setting the internal pressure of the first space (201) to a first pressure while supplying the adjustment gas into the first space (201) in which a substrate (200) including a recess formed on a surface of the substrate (200) is disposed; and
(b) after (a), supplying the etching gas into the first space (201),
wherein the internal pressure of the first space (201) is set to be lower than the first pressure during a low pressure period that is at least a partial period of (b).
